# EUROPÄISCHE PATENTANMELDUNG

(11) **EP 1 587 131 A2**
(43) Veröffentlichungstag der Anmeldung: **19.10.2005**
(21) Anmeldenummer: 05008153.8
(22) Anmeldetag: 14.04.2005
(51) Int. Cl.: H01J 37/32

(54) **Plasmareaktor mit hoher Produktivität**

(30) Priorität: 16.04.2004 DE 102004019134; 27.04.2004 DE 102004020768
(71) Anmelder: centrotherm Photovoltaics GmbH + Co. KG, 89143 Blaubeuren (DE)
(72) Erfinder: Wanka, Harald, Dr., 89143 Blaustein (DE); Reichart, Johann Georg, 89143 Blaubeuren (DE); Völk, Hans-Peter, 89608 Griesingen (DE)
(74) Vertreter: Lippert, Stachow & Partner

(57) **Zusammenfassung**

Die Erfindung betrifft einen Plasmareaktor mit hoher Produktivität zur Oberflächenbeschichtung oder -modifikation von Gegenständen bzw. Substraten mit Plasmaverfahren in einer Prozesskammer, vorzugsweise bei reduziertem Druck als vakuumprozess, mit einer Eingangsschleuse zur Prozesskammer, sowie einer Ausgangsschleuse. Mit der Erfindung soll ein Plasmareaktor mit hoher Produktivität geschaffen werden, der bei gleichbleibend hoher Produktivität eine schnelle, einfache und selektive Reinigung der Plasmaquellen sowie angrenzender Bereiche der Prozesskammer ermöglicht. Erfindungsgemäß sind zwei Plasmaquellen (1, 2) vorgesehen sind, die im Wechsel jeweils mit einer Reaktionskammer (7) oder einer Rückätzkammer (8) koppelbar sind. Die Plasmaquellen (1, 2) sind dazu an einer wechseleinrichtung (6) derart befestigt, dass die Plasmaquellen (1, 2) durch eine rotatorische Bewegung der wechseleinrichtung (6) in der Reaktionskammer (7) oder der Rückätzkammer (8) positionierbar sind.

## Beschreibung

Die Erfindung betrifft einen Plasmareaktor mit hoher Produktivität zur Oberflächenbeschichtung oder -modifikation von Gegenständen bzw. Substraten mit Plasmaverfahren in einer Prozesskammer, vorzugsweise bei reduziertem Druck als vakuumprozess, mit einer Eingangsschleuse zur Prozesskammer, sowie einer Ausgangsschleuse.

Plasmaquellen in Prozesskammern werden beispielsweise in der Halbleitertechnik zur Beschichtung von Wafern oder anderen Halbleiterstrukturen und sonstigen Substraten eingesetzt, indem die Substrate, z.B. Wafer, über die Eingangsschleuse in die Prozesskammer eingebracht werden. Nach dem Einbringen in die Prozesskammer wird ein für das nachfolgende Beschichtungs- oder Bearbeitungsverfahren geeigneter Druck durch eine Vakuumpumpe erzeugt.

Sobald der erforderliche Druck, der beispielsweise bei 0,1 - 0,2 mbar liegen kann, erreicht wird, wird die Plasmaquelle, beispielsweise ein Magnetron oder eine kapazitive Elektrode, mit einer Hochfrequenzquelle aktiviert, indem durch diese eine entsprechende Hochfrequenzenergie eingeleitet wird. Gleichzeitig wird ein geeignetes Gas in die Prozesskammer eingeleitet.

Durch das Anlegen der Hochfrequenzenergie an die Elektrode (Plasmareaktor) wird das Prozessgas in der Prozesskammer ionisiert und das in der Prozesskammer (auch als Rezipient bezeichnet) befindliche Prozessgut dem Plasma und den ionisierten Prozessgas ausgesetzt. Während des Behandlungsvorganges wird kontinuierlich frisches Prozessgas zugeführt, dass durch den Plasmareaktor/Plasmaquelle ionisiert wird und gleichzeitig während des Behandlungsvorganges verunreinigtes Prozessgas abgesaugt.

Nach der Bearbeitung des Substrates oder der Substrate in der Prozesskammer werden diese über eine Ausgangsschleuse, in der (gegebenenfalls stufenweise) zunächst der normale Umgebungsdruck eingestellt wird, nach Außen übergeben. Mit der Ausgangsschleuse wird zugleich sicher gestellt, dass keine Prozessgase in die Umwelt gelangen können.

Es ist allgemein bekannt, dass bei Beschichtungsprozessen in Bearbeitungskammern, z.B. Vakuumbearbeitungskammern, immer auch die Innenwandungen der Bearbeitungskammer, bzw. sämtliche in der Bearbeitungskammer befindlichen Einbauteile, sowie auch die Plasmaquelle selbst, mit beschichtet werden.

Diese Beschichtungen lassen sich nach dem bisher bekannt gewordenen Stand der Technik nicht verhindern. Das Ergebnis ist, dass die Produktivität solch einer Anlage durch die parasitären (unerwünschten) Beschichtungen an der Plasmaquelle oder den anderen Komponenten/Einbauteilen der Prozesskammer eingeschränkt wird. Bei Erreichen einer vorgegebenen Grenzschichtdicke müssen diese Ablagerungen entfernt werden.

Nach dem bisherigen Stand der Technik wird zum Beispiel, wie in der Mikroelektronik üblich, die Prozesskammer nach Erreichen der Grenzschichtdicke an der Plasmaquelle und den anderen Komponenten in der Prozesskammer in-situ durch Ätzen, z.B. Plasmaätzen, gereinigt. Dieses Verfahren ist allerdings dann besonders dann von Nachteil, wenn es sich um verkettete Produktionslinien handelt. In diesem Fall wird die Produktivität der gesamten Produktionslinie negativ beeinflusst.

Alternativ dazu kann die Prozesskammer natürlich auch belüftet, geöffnet und dann mechanisch manuell gereinigt werden.

Nachteilig bei beiden verfahren ist allerdings, dass die Produktivität der Anlage nicht unerheblich eingeschränkt wird, da während der Reinigung keine Beschichtungen durchgeführt werden können. Darüber hinaus ist letztere Methode äußerst partikelintensiv und es bestehen gesundheitliche Risiken für das Personal bei der Kammerreinigung.

Der Erfindung liegt daher die Aufgabe zugrunde, einen Plasmareaktor mit hoher Produktivität zu schaffen, der bei gleichbleibend hoher Produktivität eine schnelle, einfache und selektive Reinigung der Plasmaquellen sowie angrenzender Bereiche der Prozesskammer ermöglicht.

Erfindungsgemäß wird das dadurch erreicht, dass zwei Plasmaquellen vorgesehen sind, die im Wechsel jeweils mit einer Reaktionskammer oder einer Rückätzkammer koppelbar sind.

Der Plasmareaktor ist also erfindungsgemäß redundant ausgelegt, so dass ständig eine voll einsatzfähige Plasmaquelle zur Verfügung steht. Sobald die Plasmaquelle die maximal mögliche Plasmazeit erreicht hat, kann diese gegen die gereinigte Plasmaquelle in kürzester Zeit ausgetauscht werden.

Um das zu erreichen, sind die Plasmaquellen in einer Fortbildung der Erfindung an einer Wechseleinrichtung befestigt, und zwar derart, dass die Plasmaquellen durch eine vorzugsweise rotatorische bzw. translatorische Bewegung/Antrieb der wechseleinrichtung in der Reaktionskammer oder der Rückätzkammer positionierbar sind.

Für den Fall, dass die Reaktionskammer (Bearbeitungskammer) und die Rückätzkammer ortsfest montiert sind, ist es zweckmäßig, dass die Wechseleinrichtung mit den Plasmaquellen vertikal verfahrbar ist.

In einer Variante der Erfindung (also alternativ) ist vorgesehen, dass die Reaktionskammer und die Rückätzkammer senkrecht zu den Plasmaquellen verfahrbar sind. In diesem Fall kann die Wechseleinrichtung ortsfest montiert sein. In beiden Fällen ist es allerdings notwendig, die Wechseleinrichtung mit einem Drehantrieb, oder alternativ mit einem Verschiebeantrieb zu koppeln.

Um eine ausreichende Gasdichtheit sicher zu stellen, sind die Reaktionskammer und die Rückätzkammer mittels Dichtungen mit den jeweiligen Plasmaquellen gasdicht verbindbar.

Eine weitere Ausgestaltung der Erfindung ist dadurch gekennzeichnet, dass die Plasmaquellen mit der zugehörigen wechseleinrichtung, die Reaktionskammer sowie die Rückätzkammer in einer gemeinsamen Prozesskammer angeordnet sind. Damit ist es möglich, beim wechseln der Positionen der Plasmaquellen den voreingestellten Druck beizubehalten, so dass erheblich Evakuierungszeit eingespart werden kann.

Die Erfindung soll nachfolgend an einem Ausführungsbeispiel näher erläutert werden. Die zugehörige Zeichnungsfigur zeigt eine schematische Darstellung eines erfindungsgemäßen Plasmareaktors mit zwei Plasmaquellen und diesen zugeordneter Reaktions- und Rückätzkammer.

Wie bereits ausgeführt, ist das Wesen der Erfindung darin zu sehen, dass die Plasmaquellen 1, 2 redundant ausgeführt sind. Das bedeutet, dass der maximal mögliche Durchsatz bei der Beschichtung von Substrate 3 kontinuierlich gefahren werden kann.

Der erfindungsgemäße Plasmareaktor enthält zwei Plasmaquellen 1, 2 die jeweils in eine Bearbeitungsposition 4 und eine Rückätzposition 5 gebracht werden können. Zu diesem Zweck sind die Plasmaquellen 1, 2 derart an einer wechseleinrichtung 5 befestigt, dass sie wechselweise in die Bearbeitungsposition 4 in einer Reaktionskammer/Bearbeitungskammer 7 und in der Rückätzposition 5 in einer Rückätzkammer 8 gebracht werden können.

Um diese zu ermöglichen, ist die Wechseleinrichtung 6 an einer schematisch dargestellten drehbaren und vertikal anheb-und absenkbaren Aufnahme 9 befestigt, die mit einer nicht dargestellten Antriebsvorrichtung verbunden ist. Alternativ kann die Wechseleinrichtung 6 auch als Verschiebeeinrichtung ausgestaltet sein, indem die Plasmaquellen 1, 2 an entsprechenden Linearführungen befestigt sind und mittels eines Verschiebeantriebes durch eine translatorische Bewegung die jeweiligen Positionen angefahren werden können.

Um in den jeweiligen Positionen eine ausreichende Gasdichtheit zu gewährleisten, sind die Bearbeitungskammer 7 und die Rückätzkammer 8 mit Dichtungen 10, 11 versehen, die eine ausreichende Abdichtung gegenüber den Plasmaquellen 1, 2 gewährleisten.

Nach Erreichen der maximal möglichen Plasmazeit bedürfen die Plasmaquellen 1, 2 einer Reinigung. Um dies zu ermöglichen, sind die Plasmaquellen 1, 2 an der wechseleinrichtung 6 in einer Art Revolveranordnung angeordnet. Dadurch kann die "verbrauchte" Plasmaquelle 1; 2 aus der Bearbeitungskammer 7 in die Rückätzkammer 8 und gleichzeitig eine gereinigte Plasmaquelle 1; 2 aus der Rückätzkammer 8 in die Bearbeitungskammer 7 transportiert werden.

In der Rückätzkammer 8 erfolgt dann eine plasmachemische Reinigung der Plasmaquellen 1; 2 mit Hilfe eines geeigneten ionisierten Gases.

Ein besonderer Vorteil der Erfindung ist darin zu sehen, dass die Reaktionskammer/Bearbeitungskammer 7 nahezu unterbrechungsfrei mit dem vollen Durchsatz arbeiten kann. Ein weiterer Vorteil der Erfindung liegt darin, dass sowohl die Reaktionskammer 7, als auch die Rückätzkammer/Plasmareinigungskammer 8 jeweils optimal an die spezifischen Plasmabedingungen kostenoptimiert angepasst werden können.

Eine besondere Ausgestaltung der Erfindung ist dadurch gekennzeichnet, dass die Plasmaquellen 1, 2 sowie die zugehörige Wechseleinrichtung 6, die Reaktionskammer 7 und die Rückätzkammer 8 in einer gemeinsamen nur schematisch angedeuteten Prozesskammer 12 angeordnet sind. Damit ist es möglich, beim wechseln der Positionen der Plasmaquellen 1, 2 den voreingestellten Druck beizubehalten, so dass erheblich Evakuierungszeit eingespart werden kann.

Die Plasmaquellen 1, 2 sind dabei derart ausgeführt, dass durch spezielle Abschirmungen und Absaugungen die Rückätzkammer 8 von der eigentlichen Reaktionskammer 7 abgeschirmt ist, um auch hier unerwünschte Abscheidungen zu vermeiden.

### Bezugszeichenliste

- 1: Plasmaquelle
- 2: Plasmaquelle
- 3: Substrat
- 4: Bearbeitungsposition
- 5: Rückätzposition
- 6: Wechseleinrichtung
- 7: Reaktionskammer/Bearbeitungskammer
- 8: Rückätzkammer
- 9: Aufnahme
- 10: Dichtung
- 11: Dichtung
- 12: Prozesskammer

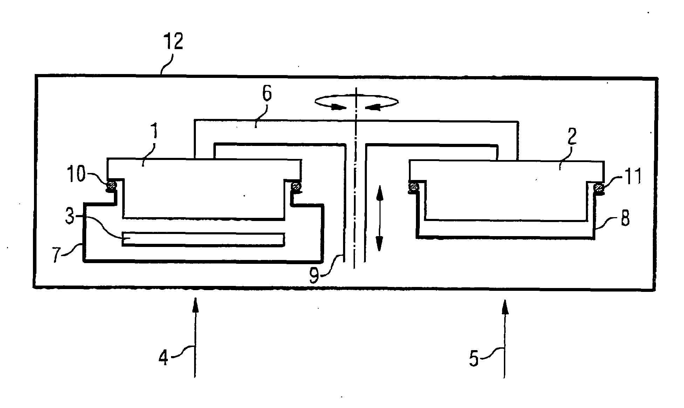

## Patentansprüche

1. Plasmareaktor mit hoher Produktivität zur Oberflächenbeschichtung oder -modifikation von Gegenständen bzw. Substraten mit Plasmaverfahren mit Plasmaquellen, vorzugsweise bei reduziertem Druck als Vakuumprozess, **dadurch gekennzeichnet, dass** zwei Plasmaquellen (1, 2) vorgesehen sind, die im Wechsel jeweils mit einer Reaktionskammer (7) oder einer Rückätzkammer (8) koppelbar sind.

2. Plasmareaktor nach Anspruch 1, **dadurch** g e**kennzeichnet**, dass die Plasmaquellen (1, 2) an einer wechseleinrichtung (6) befestigt sind, derart, dass die Plasmaquellen (1, 2) durch eine rotatorische oder translatorische Bewegung der Wechseleinrichtung (6) in der Reaktionskammer (7) oder der Rückätzkammer (8) positionierbar sind.

3. Plasmareaktor nach Anspruch 2, **dadurch gekennzeichnet, dass** die Wechseleinrichtung (6) mit den Plasmaquellen (1, 2) vertikal verfahrbar ist.

4. Plasmareaktor nach Anspruch 2, **dadurch gekennzeichnet, dass** die Reaktionskammer (7) und die Rückätzkammer (8) senkrecht zu den Plasmaquellen (1, 2) verfahrbar sind.

5. Plasmareaktor nach einem der Ansprüche 1 bis 4, **dadurch gekennzeichnet, dass** die Reaktionskammer (7) und die Rückatzkammer (8) mittels Dichtungen (10, 11) mit den Plasmaquellen (1, 2) gasdicht verbindbar sind.

6. Plasmareaktor nach einem der Ansprüche 1 bis 5, **dadurch gekennzeichnet, dass** die Plasmaquellen (1, 2) sowie die zugehörige Wechseleinrichtung (6), die Reaktionskammer (7) und die Rückätzkammer (8) in einer gemeinsamen Prozesskammer (12) angeordnet sind.
